# EUROPEAN PATENT APPLICATION

(11) **EP 3 923 468 A1**
(43) Date of publication of application: **15.12.2021**
(21) Application number: 20178882.5
(22) Date of filing: 09.06.2020
(51) Int. Cl.: H02S 50/00, H01L 25/04

(54) **METHOD FOR INCREASING THE ENERGY OUTPUT OF AN ALREADY INSTALLED SOLAR POWER PLANT, SOLAR POWER PLANT RETROFITTING SYSTEM AND SOLAR POWER PLANT**

(71) Applicant: Siemens Gamesa Renewable Energy GmbH & Co. KG, 20097 Hamburg (DE)
(72) Inventor: Wiktor, Samuel-Matthias, 22926 Ahrensburg (DE); Kayaalp, Bugra, 20535 Hamburg (DE); Krüger, Philipp, 22589 Hamburg (DE)
(74) Representative: Aspacher, Karl-Georg

(57) **Abstract**

Method for increasing the energy output of an already installed solar power plant (1) comprising at least one first solar panel (2), which is absorbing sunlight in a first frequency band, characterized in that a semi-transparent second solar panel (14, 15), which absorbs light in a second frequency band, is mounted on top of at least one of the at least one first solar panel (2) and connected to a power electronics device (8) of the solar power plant (1) comprising at least one solar inverter (9), wherein the first and second frequency bands do not or only partially overlap such that the second solar panel (14, 15) allows at least a part of the light of the first frequency band to pass.

## Description

The invention concerns a method for increasing the energy output of an already installed solar power plant comprising at least one first solar panel, which is absorbing sunlight in a first frequency band. The invention further concerns a solar power plant retrofitting system and a solar power plant.

Power plants using photovoltaics (PV) have already been proposed in the state of the art in different sizes, ranging from roof-mounted solar farms to large-scale facilities, in particular in the so-called solar belt. Solar power plants usually comprise one or more solar panels, also called photovoltaic modules (PV modules) or photovoltaic panels (PV panels). Each solar panel comprises multiple solar cells, which are also called photovoltaic cells. Solar cells are devices that convert solar radiation to electrical energy. Today, solar panels are mostly based on silicon technology, i.e. use silicon solar cells, which rely on harvesting light from a limited portion of the solar radiation spectrum. Moreover, silicon technology is close to maturity, which means that silicon-based solar panels are close to their maximum theoretical power conversion efficiency (PCE) limit. These boundary conditions limit the energy generation of silicon-based photovoltaics.

Regarding silicon-based solar panels, to improve efficiency, it has, for example, been proposed to optimize manufacturing processes to curtail efficiency losses. In other approaches, heterojunction technology (HJT) solar panels have been proposed to produce higher amounts of energy. Such HJT solar panels are comprised of more than one layer of light absorbing material deposited on top of each other to increase device performance.

In the last few years, alternative materials to silicon have also been investigated. A promising material are perovskites. A perovskite is any material having the same crystal structure as calcium titanate. Such a material, as shown in recent research projects, has the advantage of having a high absorption of light their absorbed frequency band and also high diffusion length. High efficiencies of 15% or more have been shown.

In perovskites, the band gap of the absorber material can be tuned such that certain frequency bands, in which light is absorbed, can be modified and/or displaced. In this respect, some studies have proposed so-called tandem solar cells, in which two absorber materials having different, non-overlapping frequency bands are employed, wherein the upper absorber material may be transparent regarding the frequency band absorbed by the lower material. In this manner, a larger portion of the frequency spectrum of sunlight may be absorbed and its energy can be converted to electrical energy, providing a higher efficiency. For example, in an article by David P. McMeekin et al. "A mixed-cation lead mixed-halide perovskite absorber for tandem solar cells", Science 351 (2016), pages 151 - 155, a semi-transparent perovskite device was created and the performance of a silicon solar cell after filtering the sunlight through the perovskite top cell was measured, indicating the feasibility of achieving more than 25% efficiency in perovskite/silicon tandem cells. However, such technologies are still topic of research and not yet applicable to implement a new class of solar power plants.

It is an object of the current invention to provide a possibility to increase the efficiency and thus energy output of already-installed, operational solar power plants.

This object is achieved by providing a method, a solar power plant retrofitting system and a solar power plant according to the independent claims. Advantageous embodiments are described by the dependent claims.

In a method for increasing the output of an already installed solar power plant, comprising at least one first solar panel which is absorbing sunlight in a first frequency band, according to the invention, a semi-transparent second solar panel, which absorbs light in a second frequency band not overlapping the first frequency band and allows light of the first frequency band to pass, is mounted on top of at least one of the least one first solar panel and connected to a power electronics device of the solar power plant, wherein the power electronics device comprises at least one solar inverter, wherein the first and second frequency bands to not or only partially overlap such that the second solar panel allows at least a part of the light of the first frequency band to pass.

As used in this description, a solar panel, which may also be termed photovoltaic module or photovoltaic panel, comprises multiple solar cells, which may also be called photovoltaic cells. A solar inverter, which may also be called photovoltaic inverter, is an inverter which is adapted for use with solar panels, for example implementing maximum power point tracking and/or anti-islanding protection. In large-scale power plants, a large number of first solar panels may be used, for example arranged as a so-called solar array, which may also be called photovoltaic array. Depending on the maximum power output expected, some solar power plants may include more than one solar inverter. The first solar panel used in the already installed solar power plant comprises an at least essentially flat surface, on which the sunlight shines to be at least partly absorbed by the absorber material used in the solar cells of the first solar panel. According to the invention, it is proposed to mount an additional, second solar panel onto the surface of the first solar panel, upon which the sunlight incides. The second solar panel is semi-transparent at least in the sense that at least a part of the light of the first frequency band to be absorbed by the first solar panel passes through the second solar panel, while light of the second frequency band is absorbed by the absorber material of the solar cells of the second solar panel. For example, 92 - 99%, in particular 97 - 98%, of the light of the first frequency band may be transmitted through the second solar panel, such that a low shadowing effect, for example in the range of 2 - 3%, may be existent. If, now, the second solar panel adds more energy yield, for example 5 - 15% energy yield, this shadowing effect is overcompensated such that the overall power conversion efficiency and hence the energy output of the so-retrofitted first solar panel is increased.

In other words, the energy production of operational solar power plants, in particular solar farms, may be improved by placing semi-transparent second solar panels on top of the already existing first solar panels, in particular for each of the first solar panels. A first part of the power is generated in the semi-transparent second solar panels and a second part of the power is generated by converting the remaining light energy via the underneath positioned first solar panel, since light of the first frequency band at least partially passes through the semi-transparent second solar panels. The semi-transparent solar panel absorbs light from a non-overlapping or only partially overlapping portion of the solar spectrum, that is, the second frequency band, regarding the portion of the solar spectrum absorbed by the first solar panels, that is, the first frequency band, leading to an increase in the cumulative amount of absorbed sunlight and correspondingly electrical energy.

While in preferred embodiments, the first and second frequency bands do not overlap, such that only light outside the first frequency band is absorbed for power generation by the second solar panel. In this manner, apart from a small remaining shadowing effect, light of the first frequency spectrum remains available for absorption by the first solar panel. However, in some embodiments, a small amount of overlapping of the second frequency band onto the first frequency band may be tolerable, such that still a large fraction of the second energy band covers frequencies not in the first frequency band. For example, the overlap onto the first frequency band may be less than 50%, preferably less then 20%, most preferably less than 10% of the total width of the second frequency band.

In particularly advantageous embodiments of the current invention, the first solar panel may comprise silicon solar cells, that is, may be silicon-based, and/or the second solar panel may comprise perovskite solar cells, that is, may be perovskite-based. Most of the solar power plants, in particular solar farms, that are in operation use silicon-based solar panels, for example employing amorphous silicon solar cells (a-Si), crystalline silicon solar cells (c-Si), polycrystalline solar cells (multi-Si) or monocrystalline solar cells (mono-Si). Preferably, the semi-transparent top layer of second solar panel may be based on perovskite technology, that is, comprise perovskite solar cells. While, on the one hand, perovskite is a cost-efficient absorber material, on the other hand, a perovskite-based absorber material can expediently be tuned to a second frequency band not or only slightly overlapping with the first frequency band used by common silicon-based solar panels. It is noted that, of course, other layers of the solar cells of the second solar panels are also at least semi-transparent regarding at least the first frequency band, in particular the electrodes and other layers used, wherein such (semi-)transparent, conducting electrodes and other layers have already been proposed and are known from the state of the art.

By retrofitting second solar panels harvesting light in a second frequency band not used by the first solar panel, additional power generation and thus energy generation from the operational solar power plant, in particular solar farm, is achieved. That is, the amount of power at a given point in time is increased. This advantage comes without the requirement for additional land and/or possibly power electronics, such that higher performance, and, in respect of land coverage and power electronics, lower cost are achieved. In particular, a portion of light energy that otherwise would not be used by traditional solar panels or photovoltaics is harvested by the second solar panels. The existing power electronics of the operational, already installed solar power plant can be used either with or without modification, as will be further discussed below. In some embodiments, only the at least one additional second solar panel needs to be provided, installed and connected to the power electronics device, such that, in summary, a simply realizable cost-efficient way to increase the energy output of the already installed solar power plant is provided.

If the already installed further components of the solar power plant, in particular the at least one solar inverter and/or the cable connecting the first solar panels to the power electronics device, in particular the at least one solar inverter, already have a capacity that allows for the additional power and thus energy of the second solar panels in addition to that of the first solar panels, taking into account the already mentioned shadowing effect, the second solar panel may simply be mounted and connected using the cables and power electronics already present.

If, however, installing the second solar panels would lead to power generation exceeding the power capacity of the already-installed cable and/or power electronics, several options are considered in the current invention, which may also be used in a complementary way.

Regarding the cables, it is generally envisioned that each second solar panel comprises at least one positive and at least one negative terminal. Such positive and negative terminals may be part of a junction box of the second solar panel or, generally speaking, an interface. Cables may be connected to such terminals, in particular for transporting generated DC to the power electronics device.

In an embodiment wherein the power capacity of the cables connecting the first solar panel to the power electronics device is not sufficient to sustain the increased power output of the combination of first and second solar panels at all times, the second solar panel may be connected to the power electronics device using a separate cable to the cable of the first solar panel, at least for a length of the connection distance that is covered by cable having the too low power capacity.

Regarding the at least one solar inverter, in a less preferred embodiment, the at least one pre-installed inverter may be replaced or supplemented by at least one new inverter to increase the power input capacity of the power electronics device before the second solar panel is put into operation. That is, the performance of the power electronics device may be increased according to the increased potential for power generation of the solar panels.

In other, preferred embodiments, the solar power plant may comprise multiple first solar panels, wherein only a fraction of the first solar panels are retrofitted using second solar panels, such that the power input capacity of the power electronics device is met. That is, by varying the number of second solar panels, the system may be custom-tailored to a given, nominal maximum power input capacity.

In a similar embodiment, which may also be combined with the previous embodiment, the first solar panel is only partly covered by the second solar panel. That is, the light incident surface of at least one second solar panel is smaller than the light incidence surface of the first solar panel, such that the semi-transparent top layer solar panel is sized differently than the bottom layer of the pre-existing solar panels, in particular to match the power electronics requirements. In an example, only half the surface of the first solar panel may be covered by the second solar panel.

Regarding a solar power plant retrofitting system, such a system may be modular, in particular, comprise second solar panels of different sizes. The number of second solar panels to be installed and the size can be custom-tailored to a specific, already installed solar power plant such that the full power input capacity of the power electronics device is taken advantage of.

In another approach, to match the power input capacity of the power electronics device, the orientation of the two panels, that is, the combination (structural unit) formed by mounting the second solar panel onto the first solar panel, are changed. In the case that performance improvement due to the addition of the second solar panel cannot be utilized fully due to insufficient inverter capacity, the angle and spatial configuration of the pre-existing first solar panel may be modified, for example, by changing the orientation of the first solar panel from North/South to East/West with respect to the sun, wherein subsequently, the second solar panel can be installed in the same orientation (sandwich form) to the re-oriented first solar panel. Alternatively, the second solar panel may be installed onto the pre-existing first solar panel, whereafter the orientation may be modified. Such change of orientation leads to a lower power maximum in the light harvest profile of the solar panel combination at the peak sunlight hours, whereas at the time when the sunlight incides onto the light incidence surface at an angle, the light harvest amount is increased. In other words, capacity of the at least one solar inverter is freed up regarding the first solar panel and can be utilized by the semi-transparent second solar panel, which is placed on top of the pre-existing first solar panel. A suitable orientation may be, for example, calculated and/or simulated such that the maximum power output of the retrofitted first and second solar panels is equal to or less than the maximum power input capacity of the power electronics device.

In another embodiment, the first solar panel may have a sun tracking unit associated to it for orienting the first solar panel according to a current position of the sun, wherein the control program for the sun tracking unit may be modified depending on the power input capacity of the power electronics device. Such a sun tracking unit, sometimes simply called "tracker", may adapt at least one angle of the first solar panel such that, usually, optimal efficiency is achieved. If, however, after installing the second solar panel, the efficiency of the combination leads to a power output that is too high for the power electronics device to handle, in particular during peak sunlight hours in the light harvest profile, control of the sun tracking unit may be adapted such that the power output of all solar panels in the solar power plant is always less than or equal to the power input capacity or the power electronics device. Such an embodiment employing a sun tracking unit is advantageous since the optimum efficiency may be used most of the time, while only in peak hours, efficiency has to be purposefully reduced to match the power input capacity of the power electronics device, in particular the at least one solar inverter.

In a further, advantageous embodiment to match the power input capacity of the power electronics device, for at least one of the at least one second solar panel, an electronic adaptation device may be installed, which disables the second solar panel or reduces its output when the power input capacity of the power electronics device is exceeded. That is, if at any point in time too much power as output by the combinations of first and second solar panels, at least a part of the second solar panels may be disabled and/or have their power output reduced, for example in peak sunlight hours. In concrete embodiments, the electronic adaptation device may comprise an attenuator and/or a shortcut switch. For example, the electronic adaptation device may be provided in an interface unit of the second solar panel, which may also provide the above-mentioned terminals. A control unit controlling the electronic adaptation device may also be included as a part of the second solar panel, for example as a part of the interface. In this manner, all second solar panels may be independently controlled such that a certain power output maximum for all combinations of first and second solar panels can be achieved. In other embodiments, also a central control device for all electronic adaptation devices may be provided. The control device of the solar power plant may be used. Preferably, the electronic adaptation device may be controlled based on an output current of the first and/or second solar panel. At least one corresponding sensor may be provided.

Generally, multiple options for retrofittingly mounting the second solar panel on top of the first solar panel, which are known from the state of the art, may be employed. For example, a transparent glue may be used, and/or brackets may be employed.

The invention also concerns a solar power plant retrofitting system for a solar power plant having at least one first solar panel, which absorbs light in a first frequency band, the solar power plant retrofitting system comprising at least one semi-transparent second solar panel, which absorbs light in a second frequency band, to be mounted on top of at least one of the at least one solar panel, and connection means to connect the second solar panel to a power electronics device of the solar power plant comprising at least one solar inverter, wherein the first and second frequency bands to not or only partially overlap such that the second solar panel allows at least a part of the light of the first frequency band to pass. Using the solar power plant retrofitting system of the invention, in particular by implementing the method according to the invention, an already installed solar power plant may be improved regarding efficiency, power output and, consequently, energy output. All features and comments regarding the method according to the invention correspondingly apply to the solar power plant retrofitting system according to the invention, such that the same advantages may be achieved.

In particular, the second solar panel may comprise perovskite solar cells. Further, the second solar panel may comprise at least one positive and at least one negative terminal and the connection means may comprise at least one cable for connection to the power electronics device. Such a cable may provide complete connection to the power electronics device, in particular if the power transport capacity of the already installed cable is too low, and/or may be used to join DC current produced by the second solar panel into an already installed cable transporting the DC current generated by the first solar panel.

In preferred embodiments, at least one of the at least one second solar panel may be dimensioned to only partly cover the first solar panel. In particular, the system may comprise multiple differently sized second solar panels such that a number of second solar panels to be installed may be chosen to match the power input capacity of the power electronics device of the solar power plant.

Further preferably, at least one of the at least one second solar panel may comprise an electronic adaption device to disable the second solar panel or to reduce its output when the power input capacity of the power electronics device of the solar power plant is exceeded, as described above. Hence, the electronic adaptation device may comprise an attenuator and/or a shortcut switch.

Finally, the invention also concerns a solar power plant having been retrofitted using a solar power plant retrofitting system according to the invention and/or a method according to the invention. All features and comments discussed regarding the method according to the invention and the solar power plant retrofitting system according to the invention correspondingly apply to the solar power plant according to the invention. In particular, the first solar panel may comprise silicon solar cells.

Other objects and features of the present invention will become apparent from the following detailed description considered in conjunction with the accompanying drawings. The drawings, however, are only principle sketches designed solely for the purpose of illustration and do not limit the invention. The drawings show:
- Fig. 1: a principle drawing of an already installed solar power plant,
- Fig.2: a solar power plant retrofitting system according to the invention,
- Fig. 3: a schematical drawing explaining fundamental steps of a method according to the invention,
- Fig. 4: a first solar panel oriented with respect to the sun,
- Fig 5: a combination of first and second solar panels and their orientation with respect to the sun,
- Fig. 6: an embodiment of an interface of a second solar panel, and
- Fig. 7: a graph showing solar power production and tracking angle over time of a day.

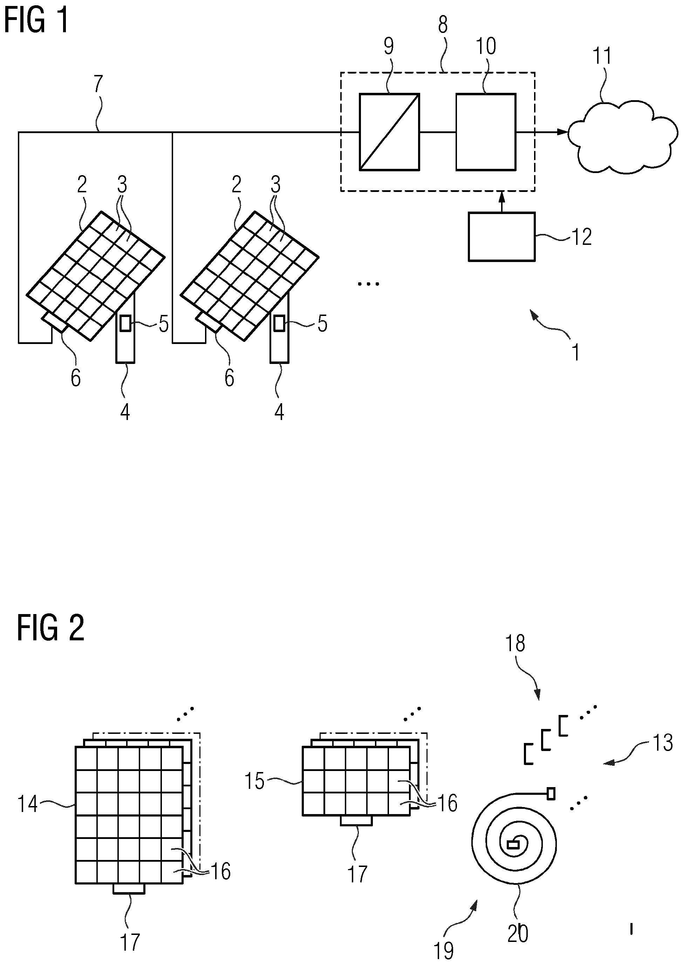

Fig. 1 is a principle drawing of an embodiment of an already installed, operational solar power plant 1. The solar power plant 1 comprises multiple first solar panels 2, each comprising multiple solar cells 3. In this embodiment, the solar cells 3 are silicon solar cells, that is, the solar panel 2 is silicon-based.

The solar system 1 may also comprise a rack or stand 4 for the solar panels 2, for example for positioning them in a certain orientation on the ground or, in other cases, on a roof or the like. Optionally, the rack or stand 4 may comprise a sun tracking unit 5 to change orientation of the solar panel 2 over time according to the current position of the sun.

The solar panels 2 may further comprise an interface 6, for example a junction box, which has, not shown in Fig. 1, at least one positive terminal and at least one negative terminal. These terminals can be used to connect cable 7, which connects the solar panel 2 to a power electronics device 8, in particular to at least one solar inverter 9 of the power electronics device 8. The power electronics device 8 may comprise further components, for example a transformer 10. The power electronics device 8 connects the solar power plant 1 to an electric grid 11.

The operation of the solar power plant 1 may be controlled a central control device 12, usually associated with or integrated into the power electronics device 8. The power electronics device 8 may, for example, be provided in a dedicated building, or, regarding smaller solar power plants, in a cabinet or the like.

Fig. 2 shows a solar power plant retrofitting system 13 according to the current invention, which can be used to increase efficiency of power conversion of sunlight to electrical power and thus energy output of an already-installed and operational solar power plant 1. The solar power plant retrofitting system 13 comprises second solar panels 14, 15, which may have different sizes, wherein, in this case, the second solar panels 14 cover the complete light incidence surface of a first solar panel 2 and the second solar panels 15 only cover half of the light incidence surface of a first solar panel 2. The second solar panels 14, 15, are semi-transparent in the sense that at least a first frequency band of the solar spectrum absorbed and converted by the solar cells 3 of the first solar panels 2 is, at least partially, transmitted through the second solar panels 14, 15, whose solar cells 16 absorb a second frequency band of the solar spectrum, which does not (or only slightly) overlap with the first frequency band, for electric power generation In this embodiment, the solar cells 16 of the second solar panels 14, 15 are perovskite solar cells, whose band gap has been tuned such that the perovskite-based absorber material absorbs in the second frequency band. The second solar panels 14, 15 further comprise an interface 17 having at least one positive and at least one negative terminal.

In an exemplary concrete embodiment, the silicon solar cells 3 may use a first frequency band in the visible to infrared spectrum, for example 500 - 800 nm wavelength, such that the perovskite solar cells 16 may use a second frequency band, for example, in the ultraviolet spectrum.

Due to the semi-transparent configuration of the second solar panels 14, 15, they may be installed on top of the first solar panels 2 to yield an increased efficiency for the combination of the two panels 2 and 14, 15. For example, the semi-transparent second solar panel 14 may transmit 97 - 98% of the sunlight in the first frequency band to the first solar panel 2, wherein the shadowing effect of 2 - 3% is overcompensated by the electrical power generated by the second solar panel by absorbing sunlight in the second frequency band. In summary, a power conversion efficiency increase is provided by retrofitting the first solar panel 2 of the already operational and installed solar power plant 1 with second solar panels 14, 15 of the solar power plant retrofitting system 13. To mount the second solar panels 14, 15 onto the first solar panel 2, the solar power plant retrofitting system 13 further comprises fixing means 18, which are exemplarily shown as brackets, but may also comprise glue, framing profiles and the like. To connect the second solar panels 14, 15 to the power electronics device 8, in particular the at least one solar inverter 9, connection means 19, in particular cables 20, may further be part of the solar power plant retrofitting system 13.

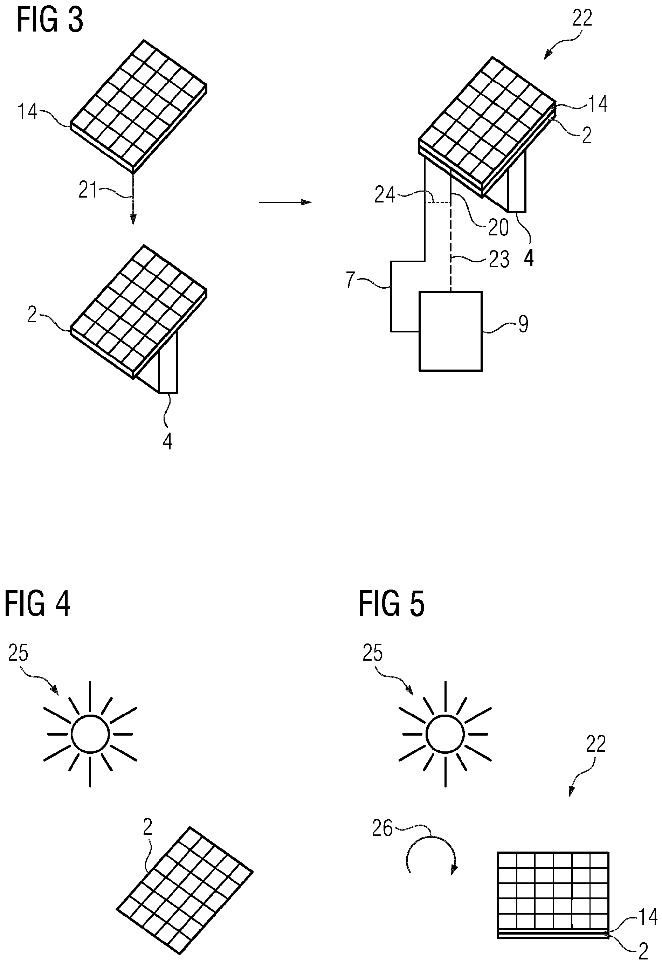

Fig. 3 illustrates basic steps of a method according to the invention, wherein a solar power plant retrofitting system 13 is used to retrofit a solar power plant 1 already in operation, hence increasing the energy output. As can be seen on the left, a second solar panel 14 is installed on top of the first solar panel 2 according to arrow 21, such that, as shown on the right of Fig. 3, a combination 22 of solar panels 2, 14 results, with the first solar panel 2 underneath the second solar panel 14 mounted on top of the first solar panel 2. If the power transport capacity, in this case the current capacity, of the already existing cables 7 would be exceeded by connecting both panels 2, 14 of the combination 22 to the inverter 9, the cable 20 may be used to fully connect the second solar panel 14 to the inverter 9, as indicated by the dashed line 23. If, however, the already existing cable 7 is configured to carry the current of both solar panels 2, 14, a shorter cable 20 may be used to connect to the cable 7, as indicated by the dotted line 24.

While some solar power plants 1 may not use the full power input capacity of their at least one solar converter 9, such that the additional power generated by the second solar panels 14, 15 may be accepted at all times, in some cases, there may be a risk of temporarily exceeding the power input capacity of the at least one solar converter 9 of the already-installed solar power plant 1. In such a case, the invention proposes multiple approaches, which may also be used additionally, that is, complementing each other. For example, as has already been explained with regard to Fig. 2, for at least a part of the first solar panels 2, smaller second solar panels 15 may be used, reducing the amount of additional electric power generated. However, it is also conceivable to only retrofit a part of the first solar panels 2 with second solar panels 14, 15. In particular, the number of solar panels 2 to be retrofitted and the size of the respective second solar panels 14, 15 may specifically be chosen such that the peak power generation expected matches the maximum power input capacity of the power electronics device 8, in particular the at least one solar inverter 9. It is noted that, in another approach, a previously installed solar inverter 9 may also be replaced or a new solar inverter 9 added to increase the maximum power input capacity of the power electronics device 8.

Fig. 4 and 5 illustrate a further approach. As shown in Fig. 4, the already installed first solar panel 2 of the not yet retrofitted solar power plant 1 has a certain orientation with respect to the sun 25, in particular chosen to maximize power generation over the day. In the case that power generation improvement after mounting the second solar panel 15 cannot be fully utilized due to insufficient inverter power input capacity, the orientation, in particular the angle and spatial configuration, can be modified, as indicated by arrow 26 of Fig. 5 and the adapted orientation of the combination 22 of first solar panel 2 and second solar panel 14. This change in orientation may be effected before or after mounting the second solar panel 14. The change in orientation leads to a lower maximum in the power generation profile of the combination 22 at the peak sunlight hours, however, the power generation may be increased at other times due to a more optimal orientation with respect to the sun 25.

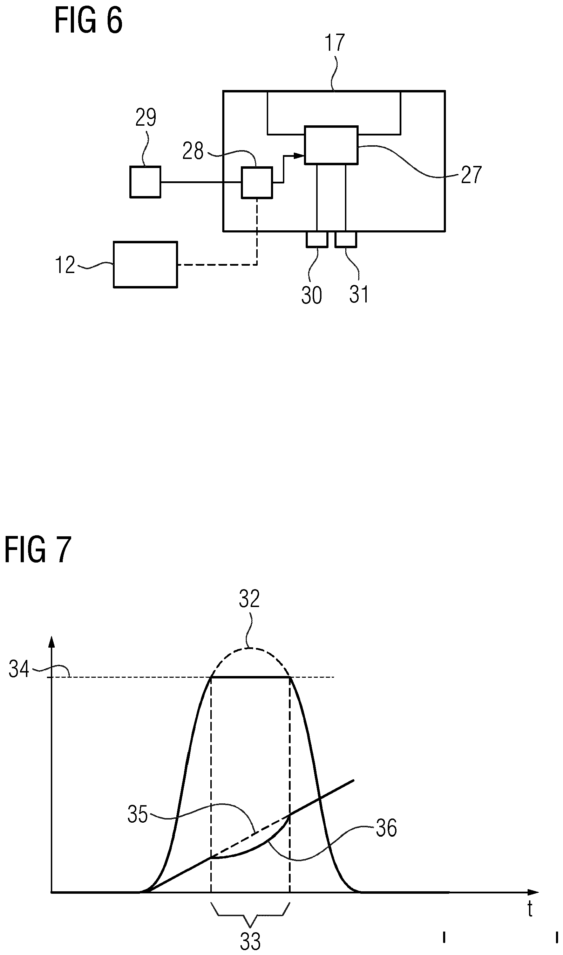

Fig. 6 shows an additional approach for limiting the maximum power output of a combination 22. In the interface 17, in this case, an electronic adaptation device 27 is provided, which may be a short circuit switch and/or an attenuator. The electronic adaptation device 27 may be controlled by a control unit 28 of the interface 17 and/or the control device 12 of the solar power plant 1, to which it may be connected. In any case, information from sensors 29, for example current sensors measuring the electrical current produced by both the first solar panel 2 and the second solar panel 14, 15, may be evaluated to decide whether a limit value is exceeded. In this case, the electronic adaptation device 27 is controlled to reduce power output, i.e. the electrical current provided at positive terminal 30 and negative terminal 31 of interface 17, by attenuation, in particular using a certain electrical resistance, or even short-circuiting the whole second solar panel 14, 15. If a connection to the control device 12 is used, a more sophisticated control method depending on power generation over all combinations 22 (and optionally non-retrofitted first solar panels 2) may also be implemented.

As already indicated regarding Fig. 1, in some solar power plants 1, sun tracking devices 5 may be used. In another approach to limit the peak power generation of the solar panels 2, 14, 15 according to the maximum power input capacity of the power electronics device 8, the control program for the sun tracking units 5 may also be modified, as exemplarily indicated in the graph of Fig. 7, wherein the curve 32 indicates the power generation of a combination 22 of first and second solar panels 2, 14, 15 over a day. As can be seen, in a time interval 33, a limit 34 is exceeded, if the sun tracking device 5 always optimally follows the position of the sun 25, as indicated by dashed curve 35. If, however, at least in the time interval 33, sun tracking is modified, for example as indicated by curve 36, that is, a non-optimal orientation with respect to the sun 25 is chosen, the generated power may be kept at or below the limit 34. The limit 34 indicates a power generation value which, if complied with by all combinations 22, ensures that the maximum power input capacity or the power electronics device 8 is not exceeded.

Although the present invention has been described in detail with reference to the preferred embodiment, the present invention is not limited by the disclosed examples from which the skilled person is able to derive other variations without departing from the scope of the invention.

## Claims

1. Method for increasing the energy output of an already installed solar power plant (1) comprising at least one first solar panel (2), which is absorbing sunlight in a first frequency band, **characterized in that** a semi-transparent second solar panel (14, 15), which absorbs light in a second frequency band, is mounted on top of at least one of the at least one first solar panel (2) and connected to a power electronics device (8) of the solar power plant (1) comprising at least one solar inverter (9), wherein the first and second frequency bands do not or only partially overlap such that the second solar panel (14, 15) allows at least a part of the light of the first frequency band to pass.

2. Method according to claim 1, **characterized in that** the first solar panel (2) comprises silicon solar cells (3) and/or the second solar panel (14, 15) comprises perovskite solar cells (16).

3. Method according to claim 1 or 2, **characterized in that** the second solar panel (14, 15), which comprises at least one positive and at least one negative terminal (30, 31), is connected to the power electronics device (8) at least partly using a separate cable (20) to the cable (7) of the first solar panel (2).

4. Method according to one of the preceding claims, **characterized in that**, before the second solar panel (14, 15) is put into operation, the at least one pre-installed inverter (9) is replaced or supplemented by at least one new inverter (9) to increase the power input capacity of the power electronics device (8).

5. Method according to one of the preceding claims, **characterized in that** the first solar panel (2) is only partly covered by the second solar panel (15) and/or the orientation of the two solar panels (2; 14, 15) is changed to match the power input capacity of the power electronics device (8).

6. Method according to one of the preceding claims, **characterized in that** the first solar panel (2) has a sun tracking unit (5) for orienting the first solar panel (2) according to a current position of the sun (25), wherein the control program for the sun tracking unit (5) is modified depending on the power input capacity of the power electronics device (8).

7. Method according to one of the preceding claims, **characterized in that** for at least one of the at least one second solar panel (14, 15), an electronic adaptation device (27) is installed, which disables the second solar panel (14, 15) or reduces its output when the power input capacity of the power electronics device (8) is exceeded.

8. Method according to claim 7, **characterized in that** the electronic adaptation device (27) comprises an attenuator and/or a shortcut switch.

9. Solar power plant retrofitting system (13) for a solar power plant (1) having at least one first solar panel (2), which absorbs light in a first frequency band, the solar power plant retrofitting system (13) comprising at least one semi-transparent second solar panel (14, 15), which absorbs light in a second frequency band, to be mounted on top of at least one of the at least one first solar panel (2) and connection means (19) to connect the second solar panel (14, 15) to a power electronics device (8) of the solar power plant (1) comprising at least one solar inverter (9), wherein the first and second frequency bands do not or only partially overlap such that the second solar panel (14, 15) allows at least a part of the light of the first frequency band to pass.

10. Solar power plant retrofitting system according to claim 9, **characterized in that** the second solar panel (14, 15) comprises perovskite solar cells (16).

11. Solar power plant retrofitting system according to claim 9 or 10, **characterized in that** the second solar panel (14, 15) comprises at least one positive and at least one negative terminal (30, 31) and the connection means (19) comprise at least one cable (20) for connection to the power electronics device (8).

12. Solar power plant retrofitting system according to any of the claims 9 to 11, **characterized in that** at least one of the at least one second solar panel (15) is dimensioned to only partly cover the first solar panel (2) and/or comprises an electronic adaptation device (27) to disable the second solar panel (14, 15) or to reduce its output when the power input capacity of the power electronics device (8) of the solar power plant (1) is exceeded.

13. Solar power plant retrofitting system according to claim 12, **characterized in that** the electronic adaptation device (27) comprises an attenuator and/or a shortcut switch.

14. Solar power plant (1) having been retrofitted using a solar power plant retrofitting system (13) according to any of the claims 9 to 13 and/or a method according to any of the claims 1 to 8.

15. Solar power plant according to claim 14, **characterized in that** the first solar panel (2) comprises silicon solar cells (3).
